# EUROPEAN PATENT APPLICATION

(11) **EP 2 093 884 A1**
(43) Date of publication of application: **26.08.2009**
(21) Application number: 08101915.0
(22) Date of filing: 22.02.2008
(51) Int. Cl.: H03M 5/00

(54) **Method for channel encoding, method and apparatus for channel decoding**

(71) Applicant: Deutsche Thomson OHG, 30625 Hannover (DE)
(72) Inventor: Theis, Oliver, 30655, HANNOVER (DE); Chen, Xiao-Ming, 30165, Hannover (DE); Timmermann, Friedrich, 30823, GARBSEN (DE)
(74) Representative: Thies, Stephan

(57) **Abstract**

A channel encoding method is disclosed, which comprises dk-encoding and NRZI precoding, the output of which obeys a repeated minimum transition runlength constraint and is FSM decodable with a given lookahead depth. Occurrences of RMTR violating critical bit sequences are replaced by same length replacement sequences containing extended zero runs; and the FSM decodability with the given lookahead depth is achieved by using only those replacement sequences that are decodable with the given lookahead depth. A pertaining FSM channel decoding method and channel decoding apparatus are disclosed.

## Description

### FIELD OF THE INVENTION

The present invention relates to channel encoding and decoding, for example to channel encoding or decoding digital data under a Repeated Minimum Transition Runlength constraint.

### BACKGROUND OF THE INVENTION

For high density optical storage, a so-called (1,7) RLL code having parity preservation and prohibiting certain RMTRs, also known as "17PP" code, is known and is being used. In this, "RLL" stands for "runlength limited", and the nomenclature "(1,7)" is a specific instance of a general, widely used nomenclature, according to which a code is termed to be "(d,k) runlength limited". The notation "(1,7) RLL" then denotes, that the code obeys a lower runlength limit of d=1 and an upper runlength limit of k=7. This means that in a sequence of code bits generated according to such a code, consecutive bits having a first binary value are separated by at least 1 and at most 7 consecutive bits having the other binary value. After a widely used NRZI modulation step, denoting a Non-Return-to-Zero-Inverted modulation, this amounts to an output bit sequence which changes its polarity after between 2 and 8 basic time intervals T. "RMTR" stands for "Repeated Minimum Transition Run", and "PP" stands for "Parity preserve / Prohibit repeated minimum-transition run". The code is of code rate 2/3, signifying that for every 2 bits of payload, 3 code bits are generated.

For the 17PP code, a decoder structured as a Finite State Machine or FSM, and having 21 states and 79 state transitions also called "branches" has been described in: MIYAUCHI et al Soft-Output Decoding of 17 Parity Preserve/Prohibit Repeated Minimum Transition Runlength (PP) Code. Japanese Journal of Applied Physics. 2004, Vol 43 No 7B, pages 4882-4883. Finite state machine decoders for binary data receive code bits in groups or tuples of a first length, and produce therefrom data bits in groups or tuples of a second length smaller than the first length. In an example FSM decoder, according to the above mentioned code rate, code tuples have a length of 3, and data tuples have a length of 2. The Miyauchi decoder can be seen to have the disadvantage of having a large number of states and state transitions corresponding to a complicated structure and a big implementation effort.

US 4337458 A describes a (1,7) RLL channel code and a pertaining FSM decoder having a markedly smaller number of 6 states and 24 state transitions. However, this code does not obey any RMTR-limitation. Depending on the data being coded, it may produce minimum transition runs of arbitrary, unlimited length. With d=1, the minimum transition run is "10", so that the repeated minimum transition run becomes (..,1,0,1,0,...). Also, the decoder of US 4337458 A is not usable on RMTR-limitation obeying codes.

Unpublished European Patent Application EP 07/107441.3, which constitutes for this application a document of prior art according to Art. 54(3) EPC, describes a channel **encoding** method and apparatus, where a known (d,k1) RLL encoding is combined with a separate postprocessing which achieves compliance with a RMTR constraint. The postprocessing does so by substituting instances of a predefined forbidden sequence, which would violate the RMTR constraint, by individual replacement sequences containing a runlength outside the internal upper runlength limit k1 but within an upper runlength limit k>k1. The individual replacement sequences are selected from a set of two predefined replacement sequences.

The encoding method of EP 07/107441.3 can be seen to have the drawback, that the bitstreams generated from that method are such, that for decoding any code tuple therefrom, the next two code tuples have also to be known. With other words, decoding the code bit sequences produced by the method of EP 07/107441.3 has a delay of two code tuples, the code bit sequences are not decodable with a lookahead of only one code tuple. This can be seen as a drawback of a more complicated decoder structure and implementation effort.

### INVENTION

It is an aspect of this invention to provide a channel encoding method the output of which is runlength limited, RMTR-limitation-obeying and low complexity FSM decodable with a lookahead of one code tuple.

It is an aspect of this invention to provide a decoding method and decoding apparatus for the runlength limited and RMTR-limitation-obeying channel code that is low complexity FSM decodable.

It is an aspect of this invention to provide a channel code which allows for DC control.

Aspects of the invention are achieved by the features in the independent claims, further developments and variants are achieved by the features in the dependent claims.

It is one embodiment of encoding according to the invention to perform a true (d,k) encoding step followed by a real replacement step as described above. Equivalently it is another embodiment of encoding according to the invention to directly provide the bitstream that results from the then merely conceptual steps of (d,k) encoding and subsequent replacement.

It is an aspect of the invention, that digital data are channel decoded by steps of, when a current state and a received code triplet are as listed in one of the lines of the Decoding Table (code according to this invention), outputting a data duplet and transiting to a next state as listed in that line of the Decoding Table.

It is an aspect of the invention, that an apparatus for channel decoding digital data has 9 states and 30 state transitions and is equipped and configured to perform a decoding method according to the invention. The apparatus allows to decode data that have been coded using an RMTR-limitation-obeying code.

It is an aspect of the invention to have recognized that among the two predefined replacement sequences generically proposed by EP 07/107441.3, one replacement sequence, when used, causes the resulting output bitstream to need a decoding lookahead of more than one code triplet. This effect occurs in two of the three cases that must be distinguished according to where in the grid of code triplets the replacement takes place. Not using those replacement sequences that would need a two code triplet lookahead, achieves that the coded bitstream is decodable witha one code triplet lookahead. This directly leads to a small and compact decoder structure. Another advantageous and astonishing fact is, that for one of the above mentioned three cases, both replacement sequences are decodable with a lookahead of one code triplet, so that for this case, a degree of freedom remains:
suitably choosing one or the other of the two predefined replacement sequences enables that the DC content or low frequency content of the resulting bitstream is influenced into a desired direction.

### DRAWINGS

Exemplary embodiments of the invention are illustrated in the drawings and are explained in more detail in the following description.

### In the Figures:

- Fig. 1: shows the state diagram of a Finite State Machine decoder according to the invention;
- Fig. 2: shows the state diagram of a Finite State Machine decoder for a known channel code.

### EXEMPLARY EMBODIMENTS

Data storage, as a transformation of signals in time, is modelled as a bandlimited channel, and for digital signal readout in particular, the bit clock is commonly regenerated from the read out signal. Both facts are reasons that Run-Length Limited channel codes also known as RLL codes are widely used on digital storage media. All through the following, we assume binary data consisting of bits having values selected from the two binary values "0" and "1". In a first conversion step, RLL channel codes convert any sequence of arbitrary payload words into a sequence of channel words that has at least a minimum number d and at most a maximum number k of "0" valued bits between consecutive "1" valued bits; in a shorthand notation, such codes are also known as "(d,k) codes", accordingly. After the conversion step, a transcoding or precoding step takes place, where the sequence of channel words from the first step is converted to an output signal or output sequence where each of the "1"s in the sequence of channel words causes a change in the output signal. With other words, whenever the sequence of channel words contains a "1", the output sequence, depending on which binary value it currently has, will change either from "0" to "1", or from "1" to "0". Where the sequence of channel words contains a "0", the output sequence maintains and repeats its current value unchanged.

In optical storage, changes of the output sequence correspond to transitions between "pit" and "space". In magnetical recording, changes are for instance between a "plus" and a "minus" magnetical orientation. The transcoding step is also known as NRZI coding. For reasons of mathematical tractability, the output values of the NRZI decoding are typically considered to be *x*∈ {-1,+1}.

Regardless of the recording technology, the limitations on the distance of the "1"s in the sequence of channel words before NRZI coding translate into the physically homogeneous regions between consecutive state changes on a storage track being of a length that is upper and lower limited to the (d+1)-fold and the (k+1)-fold, respectively, of a basic length unit often called "T".

In recent high density storage, it has been found as vital that codes additionally obey another constraint: It is forbidden, with other words it must not occur in the channel coded bitstream, that too many runs of the minimum allowed length (d+1) are immediately consecutive. This is known as a Repeated Minimum Transition Runlength or RMTR constraint, and if demanded for a storage channel, must be obeyed by any channel encoding method or apparatus to be used thereon. RMTR constrained RLL channel codes are used in recent high-density optical storage media, like blue laser optical discs. Same as the lower runlength limitation itself, the RMTR constraint aims at reducing the high frequency portions of the channel signal.

For various reasons connected to signal regeneration on the storage readout side, it is important that the output signal being written onto the medium is "DC free", with other words, that, at least on average, this signal contains as much of "pit" as of "space", or as much of "plus" as of "minus" in the magnetic case. As a criterion to measure this desirable property, the Running Digital Sum or RDS is used. In the domain of the symmetrically valued output values ∈{-1,+1} given after NRZI coding, the RDS corresponds to the time integral or sum taken from some start time t0 up to a current time t. Alternatively, the RDS is derived before the NRZI precoder, i.e. in the domain of the dk-encoded data. This amounts to sequentially using the runs of "0"s between the isolated "1"s to alternatively count up and down in an up-down-counter. In addition to the RDS itself, its variation is also used as a criterion whether a code is DC-free. This variation is often designated as Digital Sum Variation or DSV and defined as DSV=max(RDS)-min(RDS)+1.

In a digital data storage system, Error Correcting Coding also denoted as ECC is typically used: incoming data to be stored are being ECC encoded prior to being channel encoded, and correspondingly, the read back signal from the storage medium is channel decoded and then ECC decoded, in sequence. Among the many ECC decoding approaches, so-called "soft input" algorithms like those known in the art as "BCJR", "Max-Log-MAP" or "SOVA" are known to be particularly powerful, but they require a reliability or confidence information about the channel decoded symbols entering them. An important property of channel codes is whether or not they are decodable with a Finite State Machine FSM; also termed the code's "FSM decodability". Having an FSM decodable channel code is a prerequisite for using soft output channel decoding methods, which in turn provide the sought reliability information for subsequent soft decision ECC decoding, or for a soft decision joint channel and ECC decoding. In these decoding methods, which are trellis based, the state transition structure of the decoding FSM is used as a trellis.

In Finite State Machine decoding, an internal state of the decoder is determined from a current tuple of code bits, also termed a current code symbol, together with some more, subsequent code bits. In this, the number of code bits that are needed in addition to the code bits of the current code symbol, is also termed the lookahead depth of the FSM decoder. As an example, a channel code that is FSM decodable with a lookahead depth of 3 code bits means that, for determining the current state of the decoder, the code bits of the current code symbol together with 3 more, subsequent code bits from the code bit sequence are needed.

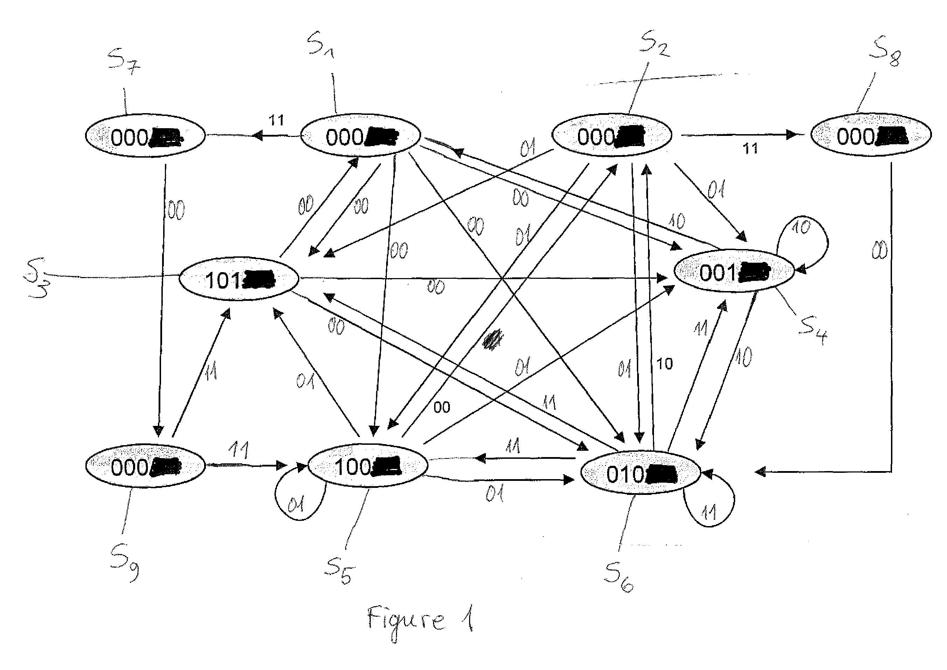

**Fig. 1** shows the state diagram of a Finite State Machine decoder according to the invention. It can best be understood by comparing it with a counterpart of a known code.

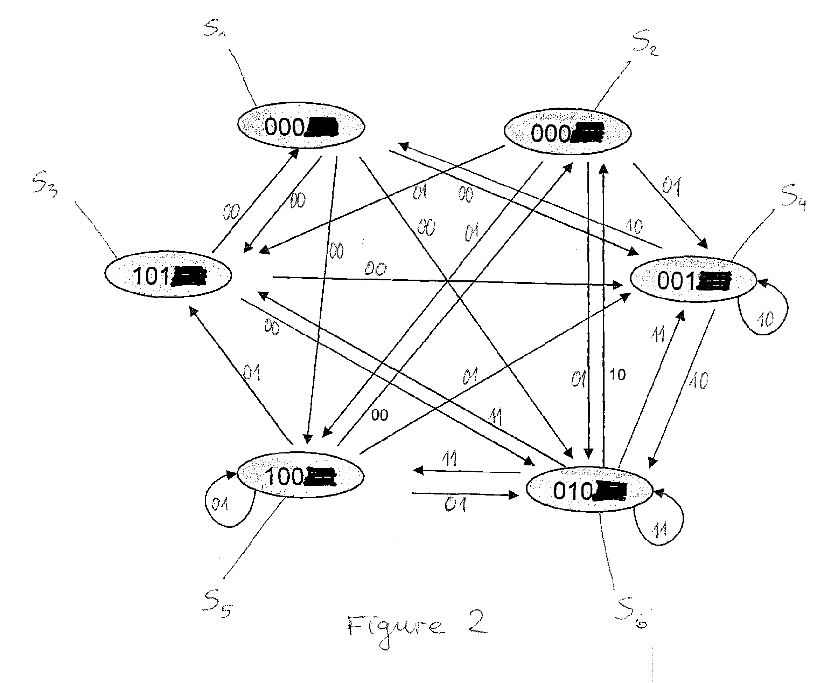

**Fig. 2** shows the state diagram of a Finite State Machine decoder for the known (1,7) RLL channel code of US 4337458 A. The code is described by its encoding rule, namely by a basic coding table and a substitution coding table. Both tables describe the transformation of certain data words - in this case data duplets comprising two bits - into code words - in this case code triplets comprising three bits. In the basic coding table, code triplets starting with a "1", as well as code triplets ending with a "1" both exist. Therefore, if just the basic coding table were applied straightforwardly, some pairs of consecutive data duplets would be transformed into consecutive code triplets where a triplet ending in a "1" is followed by a triplet starting with a "1", which would be in violation of the minimum runlength limitation d=1 of the code. In order to avoid these cases, the substitution coding table is used for those cases where the next two data duplets have one of the values listed therein. The basic coding table together with the substitution coding table completely describe the code of US 4337458 A, the code is encodable with a lookahead of two data bits. The code is also decodable with a lookahead of one code triplet, corresponding to three code bits.

| **Basiccoding table** | | **Substitution coding table** | |
|---|---|---|---|
| Data | Code | Data | Code |
| 00 | 101 | 00.00 | 101.000 |
| 01 | 100 | 00.01 | 100.000 |
| 10 | 001 | 10.00 | 001.000 |
| 11 | 010 | 10.01 | 010.000 |

With respect to the basic coding table and the substitution coding table, a widely followed notational convention is used here, in that a dot "." is written in the middle of data duplet pairs and code triplet pairs to denote those cases where a substitution according to the substitution coding table has occurred. This eases reading longer strings of data bits or code bits, because it intuitively illustrates the positions where substitutions apply. As an example, the encoding of a data bit string of "00 00 00" when written as "00.00 00" -> "101.000 101" indicates that it was the first pair of "00" duplets, and not the second one, where substitution has been applied.

The state diagram of **Fig. 2** is presented in a modified Mealy automaton style. Six balloons S1, S2, S3, S4, S5, S6 symbolise the states of the decoder, and the arrows joining them correspond to the state transitions that can regularly occur in (1,7) RLL coded sequences. A decoder output, i.e. a recognised data duplet, is associated to every state transition and is accordingly written at or near each arrow. In normal Mealy style, a decoder input, i.e. a code triplet, would also be associated to every state transition and ascribed to the arrows. But the FSM decoder of Fig. 2 has the special property that, for each specific state, all state transitions ending in that state relate to the same decoder input. This enables, that a simplified notion is used in Fig. 2, where the decoder input is ascribed to the states instead of to the state transitions. With this understanding, the diagram of Fig. 2 illustrates the decoding of any regular sequence of code triplets: A path as dictated by the code triplets in received order is being traversed in the diagram, and the output duplets of the branches thus traversed are being output sequentially.

The decoding as represented by the state diagram of Fig. 2 is equivalently described by the following decoding table, which lists, in its 24 table line entries, 24 combinations of a current state, the received code triplet, the next state, and the decoded data duplet. Each of these combinations represents one branch in the state diagram. In the decoding table the combinations are grouped and ordered by their current state and ordered by their code triplet.

**Table 1: Decoding Table (prior art code)**

| Current state | code triplet | next state | data duplet |
|---|---|---|---|
| S1 | 001 | S4 | 00 |
| S1 | 010 | S6 | 00 |
| S1 | 100 | S5 | 00 |
| S1 | 101 | S3 | 00 |
| S2 | 001 | S4 | 01 |
| S2 | 010 | S6 | 01 |
| S2 | 100 | S5 | 01 |
| S2 | 101 | S3 | 01 |
| S3 | 000 | S1 | 00 |
| S3 | 001 | S4 | 00 |
| S3 | 010 | S6 | 00 |
| S4 | 000 | S1 | 10 |
| S4 | 001 | S4 | 10 |
| S4 | 010 | S6 | 10 |
| S5 | 000 | S2 | 00 |
| S5 | 001 | S4 | 01 |
| S5 | 010 | S6 | 01 |
| S5 | 100 | S5 | 01 |
| S5 | 101 | S3 | 01 |
| S6 | 000 | S2 | 10 |
| S6 | 001 | S4 | 11 |
| S6 | 010 | S6 | 11 |
| S6 | 100 | S5 | 11 |
| S6 | 101 | S3 | 11 |

Application of the coding tables above shows that, with the (1,7) RLL channel code of US 4337458 A, a data sequence "11 00 11 00 11 00 11 ..." is coded into a repeated minimum transition run or RMTR of "010 101 010 101 010 ..." of potentially unlimited length. This illustrates that the code of US 4337458 A does not obey any RMTR limitation, the data sequence in question will be termed "critical bit sequence" in the following.

It is an aspect of the present invention, that RMTRs are being replaced in the encoding process. The overall result of runlength coding and replacing amounts to a modified channel code which does obey an RMTR limitation. Specifically, the code bit sequence "101010101010" of a sixfold RMTR is being replaced using a zero run of length greater than 7 which will translate into a corresponding run after NRZI modulation. Depending on the position of the sixfold RMTR sequence within the grid of code triplets, three cases with some replacement options have to be distinguished.

The first case is given when a data duplet of "10", translating to a code triplet of "001", precedes the sixfold RMTR sequence:
10 11 00 11 00 1X ... data
001 010 101 010 101 0?? ... (1,7) RLL code bit sequence

In this, "X" stands for a data bit having any value, i.e. "0" or "1". According to the basic coding table and the substitution coding table, a data duplet "1X" translates into code triplets "001" or "010", together symbolised here by "0??". The resulting sequence of 18 code bits exhibits a forbidden RMTR: Starting at the 3rd bit of the 1st code triplet, it contains at least 6 consecutive instances of a single "0" surrounded on both sides by "1", which is the characteristic of a short homogenious region after NRZI. For eliminating the RMTR from the code bit sequence, a first replacement sequence of "001 000 000 000 101 OXX" is used. In this, the range of changed triplets is highlighted by underlining. The replacement introduces a run of 9 consecutive "0"s. The bit sequence resulting from the replacement is decodable with a lookahead of 3 code bits.

The second case is given when a code triplet of "XXO", i.e. a code triplet that ends in a "0", precedes the sixfold RMTR sequence that results from the data duplets "11 00 ...". Such a code triplet results when the basic coding table is being applied to data duplets "01" or "11"; it also results as the second code triplet when the substitution code table is being applied to any of the data duplet pairs contained therein. The notion of the data duplet being indicated as "??", together with the code triplet being indicated as "XXO" shall symbolise these cases.
?? 11 00 11 00 11 ... data
XXO 010 101 010 101 010 ... (1,7) RLL code bit sequence

Here, a fourth replacement sequence "XXO 010 100 000 000 010" is used. As above, underlining highlights the exchanged parts. The bit sequence resulting from the replacement is decodable with a lookahead of 3 code bits.

The third case is given when a code triplet of "X00", i.e. a code triplet ending in "00", precedes the sixfold RMTR sequence that results from the data duplets "00 11 ...":
0? 00 11 00 11 0? ... data
X00 101 010 101 010 10X ... (1,7) RLL code bit sequence

Here, two replacement sequences eliminating the forbidden RMTR exist, namely a fifth replacement sequence "X00 100 000 000 010 10X" and a sixth replacement sequence "X00 101 000 000 000 10X". It is important to note, that in this third case, both replacement sequences can be decoded with a lookahead of 3 code bits, so that selectively using either the fifth or the sixth replacement sequence allows to control the DC content of the code bit sequence.

An important finding of the invention is, that even though only such replacement sequences are used, which are FSM decodable with a lookahead of three code bits, in the third case two alternatively usable replacement sequences exist. Selecting from these two possible replacement sequences constitutes a degree of freedom of the encoding process, which allows to perform a DC control of the resulting coded bitstream. With other words, by suitably selecting, whenever the third case is given, either the fifth or the sixth replacement sequence, the long term average of the outputted coded bit sequence can be influenced into a desired direction. This average corresponds to the low frequency content of the stored data signal. Having a small low frequency content is important for avoiding difficulties for any control loops of the storage system or transmission channel. These control loops may encompass focus or tracking or clock regeneration.

Other configurations of data preceding the sixfold RMTR sequence either can not occur as a regular output of the encoding as defined by the two coding tables, or are equivalent to one of the three cases considered above.

**Fig. 1** shows the state diagram of a Finite State Machine decoder according to the invention, shown in the same style as used in **Fig. 2****.** Compared to the state diagram of **Fig. 2****,** three additional states S7, S8, S9 exist, along with a total of 30 branches. Decoding the above mentioned first replacement sequence amounts to transiting the state sequence S4, S1, S7, S9, S3, S6 in that order. Decoding the above mentioned fourth replacement sequence amounts to transiting the state sequence S6, S6, S5, S2, S8, S6 in that order. For the above mentioned fifth replacement sequence, in case the leading X is "0", the decoding amounts to transiting the state sequence S2, S5, S2, S8, S6, S3 in that order. In case the leading X is "1", the decoding amounts to transiting the state sequence S5, S5, S2, S8, S6, S3 in that order. For the above mentioned sixth replacement sequence, in case the leading X is "0", the decoding amounts to transiting the state sequence S2, S3, S1, S7, S9, S3 in that order. In case the leading X is "1", the decoding amounts to transiting the state sequence S5, S3, S1, S7, S9, S3 in that order.

The state diagram of the code according to the invention, shown in Fig. 1, corresponds to the following decoding table:

| **Decoding Table (code according to this invention)** | | | |
|---|---|---|---|
| Current | code | next | data |
| state | triplet | state | duplet |
| S1 | 000 | **S7** | 11 |
| S1 | 001 | S4 | 00 |
| S1 | 010 | S6 | 00 |
| S1 | 100 | S5 | 00 |
| S1 | 101 | S3 | 00 |
| S2 | 000 | **S8** | 11 |
| S2 | 001 | S4 | 01 |
| S2 | 010 | S6 | 01 |
| S2 | 100 | S5 | 01 |
| S2 | 101 | S3 | 01 |
| S3 | 000 | S1 | 00 |
| S3 | 001 | S4 | 00 |
| S3 | 010 | S6 | 00 |
| S4 | 000 | S1 | 10 |
| S4 | 001 | S4 | 10 |
| S4 | 010 | S6 | 10 |
| S5 | 000 | S2 | 00 |
| S5 | 001 | S4 | 01 |
| S5 | 010 | S6 | 01 |
| S5 | 100 | S5 | 01 |
| S5 | 101 | S3 | 01 |
| S6 | 000 | S2 | 10 |
| S6 | 001 | S4 | 11 |
| S6 | 010 | S6 | 11 |
| S6 | 100 | S5 | 11 |
| S6 | 101 | S3 | 11 |
| S7 | 000 | S9 | 00 |
| S8 | 010 | S6 | 00 |
| S9 | 100 | S5 | 11 |
| S9 | 101 | S3 | 11 |

In the decoding table above, the modifications and extensions due to the 3 new states S7, S8, S9 are emphasized in **bold** typeface.

With other words, a channel encoding method is disclosed, which comprises dk-encoding and NRZI precoding, the output of which obeys a repeated minimum transition runlength constraint and is FSM decodable with a given lookahead depth. Occurrences of RMTR violating critical bit sequences are replaced by same length replacement sequences containing extended zero runs; and the FSM decodability with the given lookahead depth is achieved by using only those replacement sequences that are decodable with the given lookahead depth. A pertaining FSM channel decoding method and channel decoding apparatus are disclosed.

## Claims

1. Method of channel decoding a sequence of code words that is runlength-limited to within a minimum runlength of 1 and a maximum runlength of 9 and obeys an RMTR-limitation of 5 maximally allowable repetitions, the method **characterized by** steps of
- when a current state and the code word are as contained in a line of the following table, outputting a data word and transiting to a next state as contained in the line of the table.
| Current state | Code word | Next state | Data word |
|---|---|---|---|
| S1 | 000 | S7 | 11 |
| S1 | 001 | S4 | 00 |
| S1 | 010 | S6 | 00 |
| S1 | 100 | S5 | 00 |
| S1 | 101 | S3 | 00 |
| S2 | 000 | S8 | 11 |
| S2 | 001 | S4 | 01 |
| S2 | 010 | S6 | 01 |
| S2 | 100 | S5 | 01 |
| S2 | 101 | S3 | 01 |
| S3 | 000 | S1 | 00 |
| S3 | 001 | S4 | 00 |
| S3 | 010 | S6 | 00 |
| S4 | 000 | S1 | 10 |
| S4 | 001 | S4 | 10 |
| S4 | 010 | S6 | 10 |
| S5 | 000 | S2 | 00 |
| S5 | 001 | S4 | 01 |
| S5 | 010 | S6 | 01 |
| S5 | 100 | S5 | 01 |
| S5 | 101 | S3 | 01 |
| S6 | 000 | S2 | 10 |
| S6 | 001 | S4 | 11 |
| S6 | 010 | S6 | 11 |
| S6 | 100 | S5 | 11 |
| S6 | 101 | S3 | 11 |
| S7 | 000 | S9 | 00 |
| S8 | 010 | S6 | 00 |
| S9 | 100 | S5 | 11 |
| S9 | 101 | S3 | 11, |
wherein 0 signifies a first binary value, 1 signifies a second binary value different from the first binary value, and S1 to S9 signify a first to a ninth state.

2. Method of channel encoding a sequence of digital data bits into a sequence of digital code bits that is runlength-limited, RMTR-limitation-obeying and finite-state-machine decodable, the method comprising steps of
- generating, from the sequence of data bits, a sequence of interim bits by applying a finite-state-machine decodable first channel code that is runlength-limited with a minimum runlength and an internal maximum runlength;
- obtaining, from the sequence of interim bits, the sequence of code bits by localizing, in the sequence of interim bits, forbidden sequences in which a minimum runlength bit pattern is repeated more often than a maximum allowable number (r), and by replacing the forbidden sequences by replacement sequences which contain a maximum runlength pattern larger than the internal maximum runlength, **characterized in that** replacement bit sequences are used which are decodable with a lookahead depth less or equal than a predefined lookahead depth.

3. A method according to claim 2, where the forbidden sequence comprises the bit sequence "010 101 010", and the replacement sequences comprise a bit sequence of "000 000 000".

4. A method according to claim 3, where the replacement sequences comprise bit sequences from the set ("001 000 000 000 101 0", "0 010 100 000 000 010", "00 100 000 000 010 10", "00 101 000 000 000 10").

5. A method according to claim 2, where the data bits are organised in data words of a predetermined data word length, the code bits are organised in code words of a predetermined code word length larger than the data word length, the first channel code generates code words from data words, and where the predefined lookahead depth is equal to the code word length.

6. A method according to claim 5, where the data word length is 2, and the code word length is 3.

7. Apparatus for channel decoding digital data, **characterised by** being a finite state machine having 9 states and 30 state transitions and being equipped and configured to perform a decoding method according to claim 1.
